**Europäisches Patentamt**

**European Patent Office**

**Office européen des brevets**

(19)

(11) Numéro de publication : **0 445 048 A1**

# (12) DEMANDE DE BREVET EUROPEEN

(21) Numéro de dépôt : **91420053.0**

(22) Date de dépôt : **18.02.91**

(51) Int. Cl.⁵ : **H01H 71/12, H02H 1/00, G01R 1/20**

(30) Priorité : **01.03.90 FR 9002703**

(43) Date de publication de la demande :
**04.09.91 Bulletin 91/36**

(84) Etats contractants désignés :
**BE CH DE ES GB IT LI SE**

(71) Demandeur : **MERLIN GERIN**
**2, chemin des Sources**
**F-38240 Meylan (FR)**

(72) Inventeur : **Barrault, Michel**
**Merlin Gerin - Sce. Brevets**
**F-38050 Grenoble Cedex (FR)**
Inventeur : **Schuster, Philippe**
**Merlin Gerin - Sce. Brevets**
**F-38050 Grenoble Cedex (FR)**
Inventeur : **Moussanet, Roland**
**Merlin Gerin - Sce. Brevets**
**F-38050 Grenoble Cedex (FR)**
Inventeur : **Bresson, Raymond**
**Merlin Gerin - Sce. Brevets**
**F-38050 Grenoble Cedex (FR)**

(74) Mandataire : **Kern, Paul**
**Merlin Gerin Sce. Brevets 20, rue Henri Tarze**
**F-38050 Grenoble Cédex (FR)**

(54) **Capteur de courant pour un déclencheur électronique d'un disjoncteur électrique.**

(57) Un capteur de mesure (13) d'un déclencheur électronique d'un disjoncteur comporte un shunt en forme de cylindre creux (16) à l'intérieur duquel est disposé une unité électronique de traitement (23), comprenant un circuit amplificateur et une résistance d'entrée en bon contact thermique de la face interne du cylindre.

EP 0 445 048 A1

Fig .1

# CAPTEUR DE COURANT POUR UN DECLENCHEUR ELECTRONIQUE D'UN DISJONCTEUR ELECTRIQUE

L'invention est relative à un capteur de courant alternatif ou continu pour un déclencheur électronique d'un disjoncteur électrique, comprenant un shunt de forme tubulaire traversé axialement par ledit courant et un moyen électronique de mesure de la différence de potentiel produite aux bornes dudit shunt par le passage du courant.

Les déclencheurs électroniques comportent généralement des transformateurs de courant délivrant un signal proportionnel au courant qui traverse le disjoncteur. De tels déclencheurs ne fonctionnent qu'en courant alternatif et avec le développement des réseaux et appareils en courant continu, le besoin se fait sentir de disposer d'un capteur de courant universel, répondant aux courants alternatifs et continus et pouvant être mis en place dans les disjoncteurs, en remplacement des transformateurs de courant usuels. Il a déjà été proposé d'utiliser des capteurs à effet Hall, mais ceux-ci sont coûteux et mal adaptés à l'environnement d'un disjoncteur électrique.

On sait qu'une résistance shunt permet le calcul de l'intensité du courant à partir de la mesure de la différence de potentiel aux bornes de la résistance parcourue par ce courant. La résistance dissipe de l'énergie et ce principe de mesure n'est pas applicable tel quel sur les circuits de puissance, sans précautions particulières.

La présente invention a pour but de réaliser un capteur de courant simple et précis pouvant remplacer les transformateurs de courant des déclencheurs électroniques pour la mesure de courants alternatifs et continus.

Le capteur de courant selon l'invention est caractérisé en ce que ledit moyen électronique comporte un circuit amplificateur ayant une résistance d'entrée en un même matériau que ledit shunt, ladite résistance d'entrée étant physiquement associée audit shunt pour être soumise à une même répartition de température que le shunt.

La puissance dissipée dans le shunt doit être faible afin d'éviter tout échauffement excessif et seule une dissipation de quelques watts par exemple de cinq watts peut être tolérée. Il en résulte une valeur très faible de la résistance shunt, par exemple de quelques microohms pour des courants de 1000 ampères et en conséquence des différences de potentiel également très faibles, qui peuvent être masquées par des parasites, notamment par des variations de température du shunt. En réalisant selon l'invention la résistance d'entrée de l'amplificateur opérationnel en un même matériau que le shunt et en assurant une même répartition de température dans le shunt et dans la résistance d'entrée il est possible de compenser les influences de la température et de mesurer avec précision le courant traversant le shunt.

Le bon contact thermique est obtenu en réalisant la résistance d'entrée par un circuit imprimé sur une carte souple, elle-même insérée à l'intérieur du shunt tubulaire et plaquée contre toute la surface interne du shunt. Le dessin de cette résistance est optimisé afin de minimiser la valeur de son inductance. La répartition linéaire de la résistance d'entrée dans la direction axiale du shunt permet de s'affranchir du gradient de température le long du shunt, dû à des différences de température entre les deux extrémités.

Les parasites induits par les circuits de puissance peuvent être atténués ou annulés en disposant l'unité de traitement du signal de mesure à proximité immédiate du shunt de mesure et selon l'invention elle est disposée sur un support inséré dans le shunt tubulaire. Le support en forme de carte est avantageusement relié mécaniquement et électriquement à la carte de support de la résistance d'entrée par un lien souple, monobloc ou non avec les cartes. Cette disposition limite également l'influence des phases voisines. La précision de la chaîne de mesure peut être augmentée en prévoyant deux résistances d'entrée, chacune reliée à l'une des entrées de l'amplificateur, les deux résistances étant identiques et dans le même matériau que le shunt. Les forces électromotrices résultant des thermocouples aux jonctions électriques sont ainsi compensées. En imbriquant sur la carte les circuits, formant les deux résistances d'entrée, et en réalisant des demi-spires parcourues par des courants de sens opposé, les courants induits notamment par les phases voisines sont également compensés. L'ensemble est compact et peut être logé à l'emplacement des transformateurs de courant dans les boîtiers des disjoncteurs. Des essais ont confirmé la précision de mesure d'un courant de 100 ampères à 3 % près, le shunt étant réalisé en cuivre.

D'autres avantages et caractéristiques ressortiront plus clairement de la description qui va suivre d'un mode particulier de réalisation de l'invention, donné à titre d'exemple non limitatif et représenté au dessins annexés dans lesquels :

    – la figure 1 est une vue schématique en coupe d'un disjoncteur équipé d'un capteur de courant selon l'invention;

    – la figure 2 est une vue à échelle agrandie du capteur de la fig. 1;

    – la figure 3 est une vue de dessous du capteur selon la fig. 2;

    – la figure 4 montre le schéma électrique;

    – les figures 5, 6 et 7 sont des vues schématiques en perspectives du shunt, de la résistance d'entrée et de l'unité de traitement pendant les différentes phases d'insertions à l'intérieur du shunt;

– la figure 8 est une vue déployée de deux résistances d'entrée.

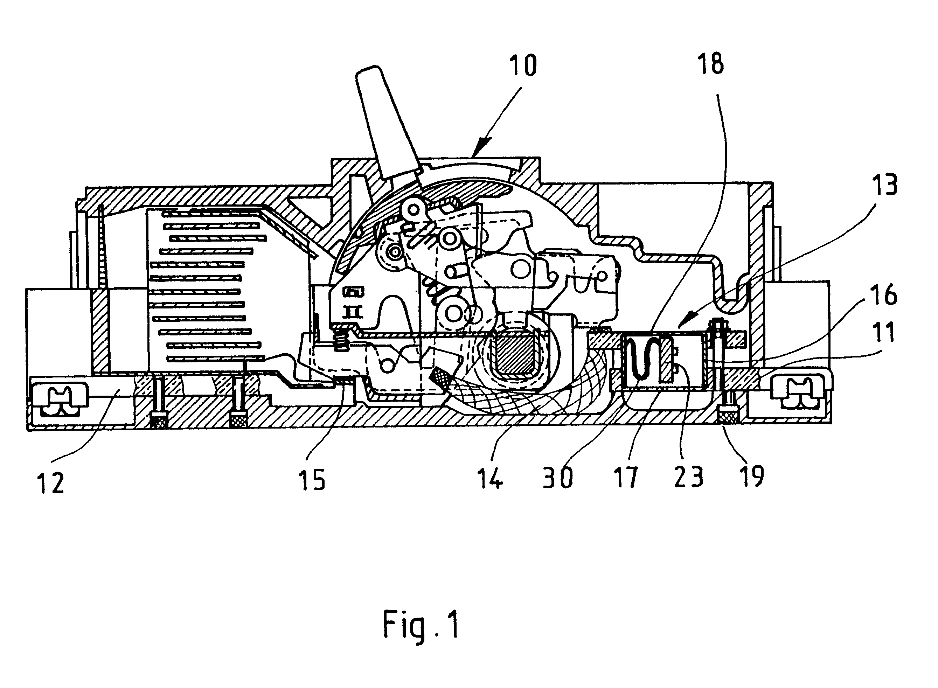

Sur la figure 1, un disjoncteur 10 à boîtier moulé comporte des plages d'entrée et de sortie 11,12 entre lesquelles sont connectés en série un capteur de courant 13, une tresse 14 et une paire de contacts 15. Le capteur de courant 13 délivre un signal proportionnel au courant traversant le disjoncteur 10 pour provoquer le déclenchement lorsque ce courant dépasse un seuil prédéterminé. Un tel disjoncteur est décrit dans le brevet français 2.583.570 auquel on se reportera pour de plus amples détails.

Le capteur 13 est constitué par un cylindre creux 16 inséré entre deux fonds 17,18, dont l'un 17 à proximité de la base 19 du boîtier est un prolongement de la plage d'entrée 11 et dont l'autre 18 opposé s'étend vers la tresse 14 qui y est fixée. L'axe du cylindre 16 est perpendiculaire à la base 19 et aux deux fonds 17,18 et les extrémités du cylindre 16 sont emboîtées dans des logements borgnes conjugués 20,21 creusés dans l'épaisseur des fonds 17,18, l'ensemble étant maintenu et fixé par une ou plusieurs vis isolantes 22 qui relient les deux fonds 17,18. Le courant entrant à un instant donné par la plage 11 traverse axialement le cylindre creux 16, la tresse 14, la paire de contacts 15 avant de sortir par la plage 12. Le cylindre 16 est en cuivre et ses dimensions sont choisies pour présenter une résistance de quelques microohms, par exemple de 5 microohms. La puissance dissipée lors du passage du courant dans cette résistance est donc faible et on évite ainsi un échauffement excessif.

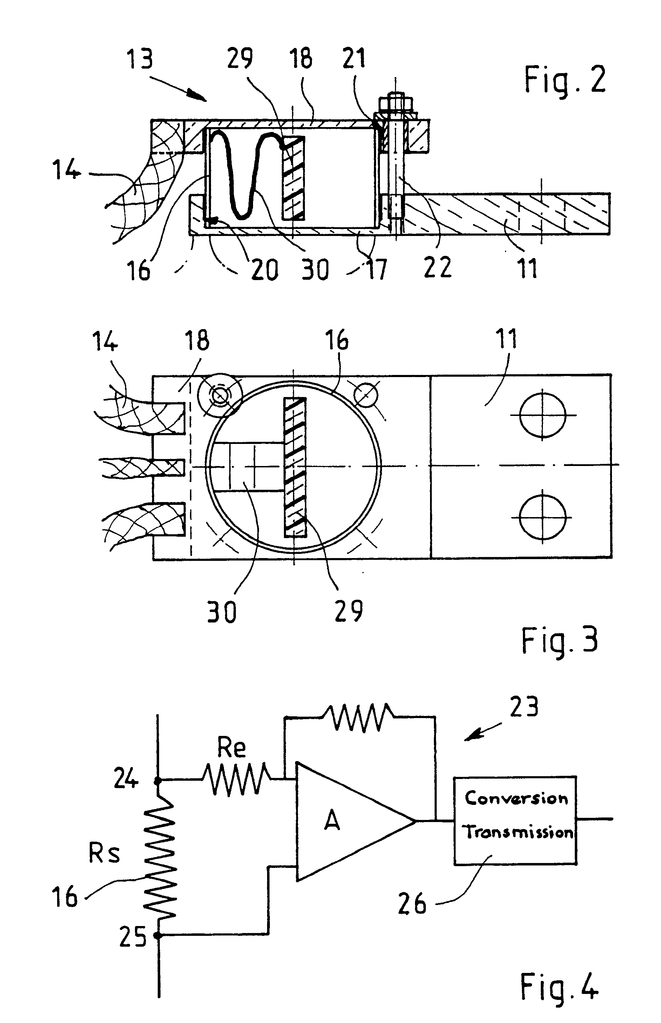

Aux extrémités ou bornes de la résistance shunt, constituée par le cylindre creux 16, apparaît une différence de potentiel qui est proportionnelle au courant traversant le cylindre 16 et cette différence de potentiel est mesurée par une unité électronique de traitement 23 à technologie intégrée, dont le schéma général est représente à la figure 4. Aux bornes 24,25 de la résistance shunt Rs, sont connectées les deux entrées d'un circuit amplificateur A avec une résistance d'entrée Re insérée dans le circuit de liaison, de la borne 24 à l'entrée associée.

L'amplificateur opérationnel A délivre un signal représentatif de cette différence de potentiel aux bornes 24,25, lequel signal est appliqué à un bloc 26 de conversion et de transmission.

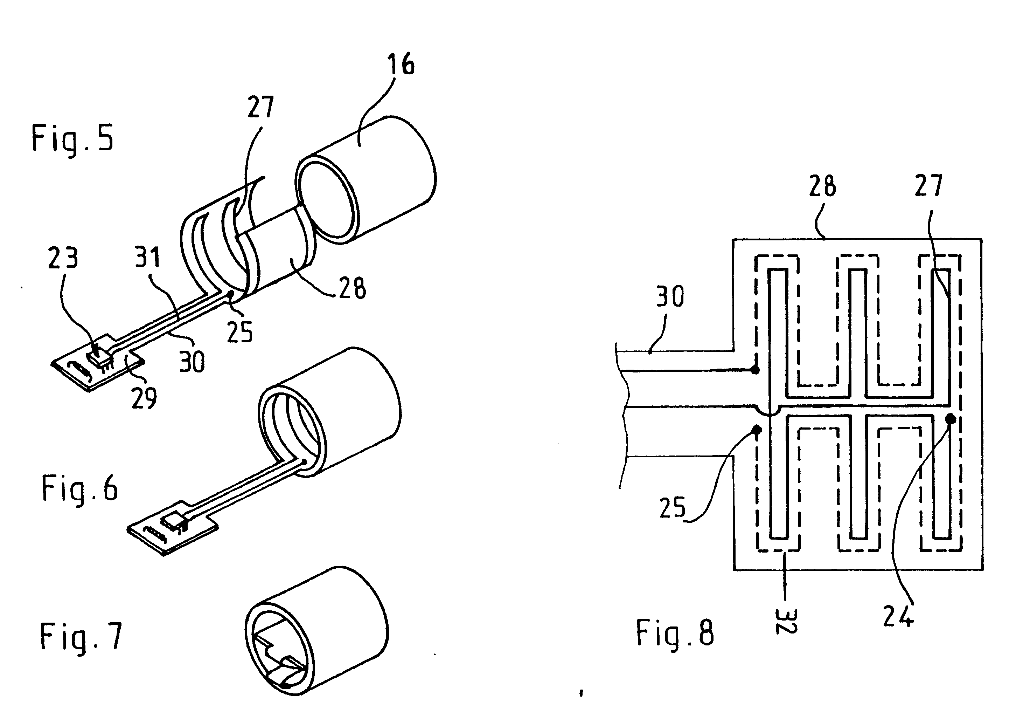

En se référant aux figures 5 et 7 on voit que la résistance d'entrée Re est formée par un circuit imprimé 27 sur une carte souple 28 rectangulaire qui peut être pliée et glissée à l'intérieur du cylindre 16 en se plaquant sur toute la surface interne du cylindre 16 en bon contact thermique de ce dernier. Le circuit imprimé 27, représenté sur les figures, est à simple face, mais il peut être à double face isolée du cylindre 16 et il est connecté au cylindre 16, en l'occurrence à la borne 24, par soudure traversante ou non, ou par une colle ou film conducteur, ou tout autre moyen. L'électronique de traitement 23 est portée par un support rigide 29, relié mécaniquement par une languette souple 30 à la carte souple 28 et cette languette 30 porte les deux conducteurs 31 de liaison entre la résistance shunt Rs et l'unité électronique de traitement 23. L'un de ces conducteurs 31 est connecté à la borne 25 ou extrémité correspondante du cylindre 16, tandis que l'autre est connecté à la résistance Re, formée par le circuit imprimé 27, connecté à la borne opposée 24. En déployant le support 28 et la languette 30 il est facile de réaliser l'électronique de mesure 23,27 associée au shunt 16 et cette électronique est ensuite insérée à l'intérieur du cylindre creux, le support 29 étant glissé à l'intérieur de la carte souple 28 repliée en cylindre, elle-même glissée dans le cylindre 16. La souplesse de la carte 28 et de la languette 30 permet ce mode de réalisation, mais il est clair que l'invention n'est pas limitée à cette réalisation particulière.

Le circuit imprimé 27 est réparti linéairement le long du cylindre 16 et il est soumis à la même répartition de température que ce cylindre. En réalisant la résistance d'entrée Re, en l'occurrence le circuit imprimé 27, dans le même matériau que la résistance shunt Rs on obtient une compensation en température et grâce à la répartition régulière sur toute la surface du cylindre 16 on s'affranchit également de tout gradient de température le long de ce cylindre.

L'unité de traitement 23 du signal est à proximité du lieu de mesure et à l'intérieur du cylindre 16, qui forme un écran, ce qui limite les risque de perturbations par les courants de puissance, notamment des phases voisines du disjoncteur.

Les tensions mesurées sont de quelques microvolts, c'est-à-dire de l'ordre de grandeur des forces électromotrices thermoélectriques engendrées aux jonctions, qui doivent être particulièrement soignées. La précision peut être accrue en symétrisant les deux entrées de l'unité de traitement 23 par adjonction d'une deuxième résistance d'entrée Re en bon contact thermique du cylindre 16.

La figure 8 représente schématiquement une réalisation préférentielle de deux circuits imprimés, l'un 27 représenté en trait continu et l'autre 32 en trait discontinu, formant les deux résistances d'entrée Re. Le circuit 27 est connecté à la borne 24 et le circuit 32 à la borne 25 et les deux circuits 27,32, en forme de demi-spires, s'étendent sur toute la surface de la carte 28 en étant imbriqués de manière que deux conducteurs adjacents des deux circuits 27,32 sont toujours en sens opposé. On obtient ainsi une compensation qui participe à la précision de la mesure.

L'encombrement du capteur est faible et celui-ci peut aisément être logé dans l'emplacement des transformateurs de courant.

L'invention n'est pas limitée au mode de mise en oeuvre plus particulièrement décrit, mais elle s'étend à toute variante restant dans le cadre des équivalences, notamment à celle dans laquelle le shunt présenterait une section ou une disposition différente.

## Revendications

1. Capteur (13) de courant alternatif ou continu pour un déclencheur électronique d'un disjoncteur électrique, comprenant un shunt (16) traversé par ledit courant et un moyen électronique de mesure (23) de la différence de potentiel produite aux bornes dudit shunt (16) par le passage du courant, dans lequel ledit moyen électronique comporte un circuit amplificateur (A) ayant une résistance d'entrée (27) en un même matériau et soumise à une même répartition de température que le shunt, caractérisé en ce que ledit shunt est en forme de cylindre creux traversé axialement par le courant et intercalé entre deux plaques conductrices formant les fonds dudit cylindre et que ladite résistance d'entrée (27) est réalisée par une carte à circuit imprimé (28) insérée dans ledit cylindre (16) et maintenue en bon contact thermique avec la face interne du cylindre, la résistance d'entrée étant répartie linéairement dans la direction de l'axe du shunt.

2. Capteur selon la revendication 1, caractérisé en ce que ladite carte (28) est en un matériau souple et gaine entièrement la surface interne cylindrique du shunt (16).

3. Capteur de courant selon la revendication 1 ou 2, caractérisé en ce que ladite carte (28) présente une extension souple (30) de liaison mécanique et électrique à un support (29) dudit circuit amplificateur.

4. Capteur de courant selon la revendication 3, caractérisé en ce que l'amplificateur (A) et son support (29) sont insérés à l'intérieur dudit cylindre (16) avec pliage de ladite extension souple (30).

5. Capteur de courant selon l'une quelconque des revendications précédentes, caractérisé en ce qu'il comporte deux résistances d'entrée (27,32) connectées respectivement aux entrées dudit amplificateur (A) et imbriquées symétriquement sur ladite carte (28).

6. Capteur de courant selon la revendication 5, caractérisé en ce que lesdites deux résistances d'entrée (27,32) sont imbriquées en demi-spires parcourues par des courants de sens opposé.

Fig.1

EP 0 445 048 A1

Fig. 2

Fig. 3

Conversion
Transmission

Fig. 4

Fig.8

Fig.5

Fig.6

Fig.7

Office européen
des brevets

# RAPPORT DE RECHERCHE EUROPEENNE

Numéro de la demande

EP 91 42 0053

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| A | GB-A-2056182 (FERRANTI LIMITED)<br>* page 1, lignes 22 - 31 *<br>--- | 1 | H01H71/12<br>H02H1/00<br>G01R1/20 |
| A | EP-A-0184609 (ANT NACHRICHTENTECHNIK)<br>* pages 3 - 6 *<br>--- | 1 | |
| A | DE-A-3724116 (WESTINGHOUSE)<br>* colonne 5, ligne 50 - colonne 7, ligne 50 *<br>--- | 1 | |
| A | FR-A-2568684 (LA TELEMECANIQUE ELECTRIQUE)<br>* abrégé *<br>----- | 1 | |
| | | | **DOMAINES TECHNIQUES RECHERCHES (Int. Cl.5 )**<br><br>H02H<br>G01R<br>H01H |

Le présent rapport a été établi pour toutes les revendications

| Lieu de la recherche | Date d'achèvement de la recherche | Examinateur |
|---|---|---|
| LA HAYE | 10 JUIN 1991 | LIBBERECHT L.A. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)